# EUROPEAN PATENT APPLICATION

(11) **EP 1 870 941 A1**
(43) Date of publication of application: **26.12.2007**
(21) Application number: 07108427.1
(22) Date of filing: 17.05.2007
(51) Int. Cl.: H01L 29/788, H01L 29/792

(54) **Non-volatile memory device having four storage node films and methods of operating and manufacturing the same**

(30) Priority: 23.06.2006 KR 20060057088
(71) Applicant: Samsung Electronics Co., Ltd., Suwon-si 442-742 Gyeonggi-do (KR)
(72) Inventor: Park, Yoon-dong c/o Samsung Advanced Institute of Technology, Yongin-si, Gyeonggi-do (KR); Kim, Suk-pil c/o Samsung Advanced Institute of Technology, Yongin-si, Gyeonggi-do (KR); Hyun, Jae-woong c/o Samsung Advanced Institute of Technology, Yongin-si, Gyeonggi-do (KR)
(74) Representative: Greene, Simon Kenneth

(57) **Abstract**

A nonvolatile memory device that may operate in a multi-bit mode and a method of operating and manufacturing the nonvolatile memory device are provided. The nonvolatile memory device may include a first source region and a first drain region that are respectively in first fin portions on both sides of a control gate electrode and respectively separated from the control gate electrode, a second source region and a second drain region that are respectively formed in second fin portions on both sides of the control gate electrode and respectively separated from the control gate electrode, first and second storage node layers that are formed with the control gate electrode therebetween and on the side of the first fin opposite to a buried insulating layer between first and second fins, and third and fourth storage node layers that are formed with the control gate electrode therebetween and on the side of the second fin opposite to the buried insulating layer.

## Description

### BACKGROUND OF THE INVENTION

Example embodiments relate to a semiconductor device and methods of operating and manufacturing the same. Other example embodiments relate to a nonvolatile memory device including a fin type channel region and a method of operating and manufacturing the nonvolatile memory device.

The volume of semiconductor components is becoming smaller and more quantity of data processing is being required. Accordingly, ways to increase the operation speed and the degree of integration of nonvolatile memory devices have been researched. For example, in a semiconductor device in which integration is improved using a fin-field effect transistor (fin-FET), the operation speed may be increased by expanding the area of the channel, and at the same time, the integration may be improved by reducing the width of the fin. Moreover, a fin-FET may improve the short channel effect using a silicon-on-insulator (SOl) substrate. For example, the conventional art discloses a fin-FET and a Fin memory cell and a fin-FET using an SOI substrate.

Because SOI substrates are relatively expensive, fin-FET or fin memory cells using a bulk semiconductor substrate having similar properties as the SOI substrate have been attempted in manufacturing. Conventional fin memory cells may have a stack structure in which a tunnel insulating layer, a storage node layer, a blocking insulating layer, and a control gate electrode are stacked at fins, but may be limited in reducing the spacing between the fins. A memory device to realize multi-bit operation to increase the data processing speed may be required.

### SUMMARY OF THE INVENTION

Example embodiments provide a nonvolatile memory device that may be highly integrated and may operate in a multi-bit mode. Example embodiments also provide a method of multi-bit operation of the nonvolatile memory device and a method of manufacturing the nonvolatile memory device.

According to example embodiments, a nonvolatile memory device may include a first source region and a first drain region that are respectively in first fin portions on both sides of a control gate electrode and respectively separated from the control gate electrode, a second source region and a second drain region that are respectively formed in second fin portions on both sides of the control gate electrode and respectively separated from the control gate electrode, first and second storage node layers that are formed with the control gate electrode therebetween and on the side of the first fin opposite to a buried insulating layer between first and second fins, and third and fourth storage node layers that are formed with the control gate electrode therebetween and on the side of the second fin opposite to the buried insulating layer.

The nonvolatile memory device may further include a semiconductor substrate including the first and second fins, a control gate electrode on the sides of the first and second fins opposite to the buried insulating layer and extending onto the buried insulating layer, and a gate insulating layer between the first and second fins and the control gate electrode. The nonvolatile memory device may also include a first tunnel insulating layer between the first fin and the first and second storage node layers and a second tunnel insulating layer between the second fin and the third and fourth storage node layers. The gate insulating layer and the first and second tunnel insulating layers may include an oxide layer. The thicknesses of the gate insulating layer and the first and second tunnel insulating layers may be different from each other.

The nonvolatile memory device may further include a first blocking layer between the control gate electrode and the first and second storage node layers and a second blocking insulating layer between the control gate electrode and the third and fourth storage node layers. At least a portion of the first and second storage node layers may not overlap with the first source region and the first drain region. At least a portion of the third and fourth storage node layers may not overlap with the second source region and the second drain region. The semiconductor substrate may be an etched bulk semiconductor wafer. The first, second, third, and fourth storage node layers may include at least one selected from the group consisting of a silicon nitride layer, dots of metal or silicon, and nano-crystals of metal or silicon. The semiconductor substrate may include a body and first and second fins that protrude from the body. The control gate electrode may be insulated from the semiconductor substrate.

According to example embodiments, a method of operating a nonvolatile memory device may include programming data of at least 4 bits to first, second, third, and fourth storage node layers, reading data stored in the first, second, third, and fourth storage node layers and erasing the data stored in the first, second, third, and fourth storage node layers.

Programming the data may include using a hot electron injection (HEI) method. Data programming may be performed by supplying a turn-on voltage to a control gate electrode and by alternately applying currents in opposite directions to each other between a first source region and a first drain region and between a second source region and a drain region. Reading the data may include measuring the leakage current of a first source region and a first drain region and the leakage current of a second source region and a second drain region. In reading the data, a turn-off voltage may be supplied to a control gate electrode. Erasing the data may include using a hot hole injection (HHI) method. Data erasing may be performed by supplying a negative voltage to a control gate electrode and by supplying a positive voltage to at least one of a first source region, a first drain region, a second source region, and a second drain region. In erasing the data, the semiconductor substrate may be grounded.

According to example embodiments, a method of manufacturing a nonvolatile memory device may include forming a first source region and a first drain region that are respectively in the first fin portions on both sides of a control gate electrode and respectively separated from the control gate electrode, forming a second source region and a second drain region on the second fin portions on both sides of the control gate electrode and respectively separated from the control gate electrode, forming first and second storage node layers with the control gate electrode therebetween and on the side of the first fin opposite to a buried insulating layer between first and second fins and forming third and fourth storage node layers with the control gate electrode therebetween and on the side of the second fin opposite to the buried insulating layer.

The method may further include providing a semiconductor substrate including the first and second fins, forming a control gate electrode on the sides of the first and second fins opposite to the buried insulating layer and extending onto the buried insulating layer, and forming a gate insulating layer between the first and second fins and the control gate electrode. The method may further include forming a first tunnel insulating layer between the first fin and the first and second storage node layers, and forming a second tunnel insulating layer between the second fin and the third and fourth storage node layers. The gate insulating layer and the first and second tunnel insulating layers may include an oxide layer. The thicknesses of the gate insulating layer and the first and second tunnel insulating layers may be different from each other.

The method may further include forming a first blocking layer between the control gate electrode and the first and second storage node layers, and forming a second blocking insulating layer between the control gate electrode and the third and fourth storage node layers. At least a portion of the first and second storage node layers may not overlap with the first source region and the first drain region. At least a portion of the third and fourth storage node layers may not overlap with the second source region and the second drain region. The semiconductor substrate may be an etched bulk semiconductor wafer. Forming the first, second, third, and fourth storage node layers may include at least one selected from the group consisting of a silicon nitride layer, dots of metal or silicon, and nano-crystals of metal or silicon. The semiconductor substrate may include a body and first and second fins that protrude from the body. The control gate electrode may be insulated from the semiconductor substrate.

### BRIEF DESCRIPTION OF THE DRAWINGS

Example embodiments will be more clearly understood from the following detailed description taken in conjunction with the accompanying drawings. FIGS. 1-9 represent non-limiting, example embodiments as described herein.
FIG. 1 is a perspective view of a nonvolatile memory device according to example embodiments;
FIG. 2 is a plan view of the nonvolatile memory device of FIG. 1;
FIG. 3 is a cross-sectional view of the nonvolatile memory device of FIG. 1 cut along a line III-III';
FIG. 4 is a cross-sectional view of the nonvolatile memory device of FIG. 1 cut along a line IV-IV';
FIGS. 5 and 6 are cross-sectional views showing the programming operation of the nonvolatile memory device of example embodiments;
FIGS. 7 and 8 are cross-sectional views showing the reading operation of the nonvolatile memory device of example embodiments; and
FIG. 9 is a cross-sectional view showing the erasing operation of the nonvolatile memory device of example embodiments.

### DETAILED DESCRIPTION OF EXAMPLE EMBODIMENTS

Example embodiments will now be described more fully with reference to the accompanying drawings, in which example embodiments are shown. Example embodiments may, however, be embodied in many different forms and should not be construed as being limited to the embodiments set forth herein; rather, these embodiments are provided so that this disclosure will be thorough and complete, and will fully convey the concept of example embodiments to those skilled in the art. In the drawings, the thicknesses of layers and regions are exaggerated for clarity.

It will be understood that when an element or layer is referred to as being "on," "connected to" or "coupled to" another element or layer, it can be directly on, connected or coupled to the other element or layer or intervening elements or layers may be present. In contrast, when an element is referred to as being "directly on," "directly connected to" or "directly coupled to" another element or layer, there are no intervening elements or layers present. As used herein, the term "and/or" includes any and all combinations of one or more of the associated listed items.

It will be understood that, although the terms first, second, etc. may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second element, component, region, layer or section without departing from the teachings of example embodiments.

Spatially relative terms, such as "beneath," "below." "lower," "above," "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the example term "below" can encompass both an orientation of above and below. The device may be otherwise oriented (rotated 90 degrees or at other orientations) and the spatially relative descriptors used herein interpreted accordingly.

The terminology used herein is for the purpose of describing particular embodiments only and is not intended to be limiting of example embodiments. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements and/or components, but do not preclude the presence or addition of one or more other features, integers, steps, operations, elements, components and/or groups thereof.

Example embodiments are described herein with reference to cross-section illustrations that are schematic illustrations of idealized embodiments (and intermediate structures). As such, variations from the shapes of the illustrations as a result, for example, of manufacturing techniques and/or tolerances, are to be expected. Thus, example embodiments should not be construed as limited to the particular shapes of regions illustrated herein but are to include deviations in shapes that result, for example, from manufacturing. For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place. Thus, the regions illustrated in the figures are schematic in nature and their shapes are not intended to illustrate the actual shape of a region of a device and are not intended to limit the scope of example embodiments.

Unless otherwise defined, all terms (including technical and scientific terms) used herein have the same meaning as commonly understood by one of ordinary skill in the art to which example embodiments belong. It will be further understood that terms, such as those defined in commonly used dictionaries, should be interpreted as having a meaning that is consistent with their meaning in the context of the relevant art and will not be interpreted in an idealized or overly formal sense unless expressly so defined herein.

The term "hot carriers" refers to hot electrons or hot holes that have gained relatively high kinetic energy after being accelerated by a relatively strong electric field in areas of high field intensities within a semiconductor device. Because of their relatively high kinetic energy, hot carriers may get injected and trapped in areas of the device where they shouldn't be, forming a space charge that causes the device to degrade or become unstable.

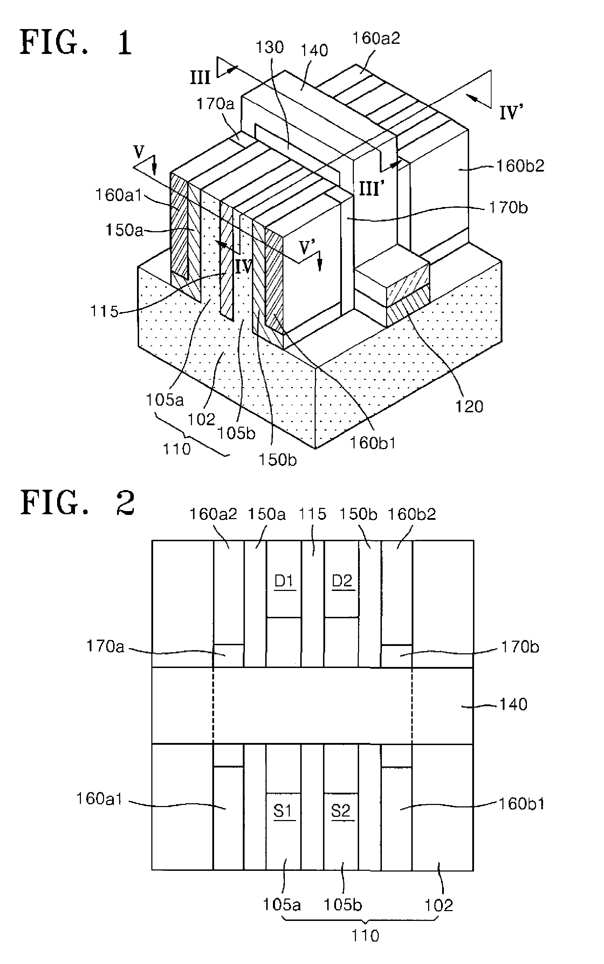

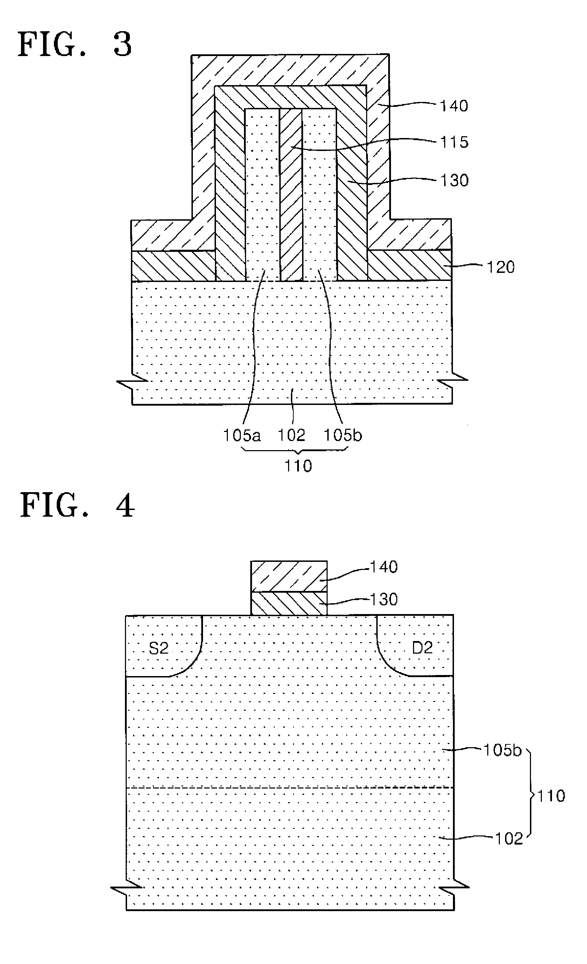

FIG. 1 is a perspective view of a nonvolatile memory device according to example embodiments; FIG. 2 is a plan view of the nonvolatile memory device of FIG. 1; FIG. 3 is a cross-sectional view of the nonvolatile memory device of FIG. 1 cut along a line III-III'; and FIG. 4 is a cross-sectional view of the nonvolatile memory device of FIG. 1 cut along a line IV-IV'. The nonvolatile memory device according to example embodiments may be illustrated by a unit cell structure. For example, the unit cell structure may be used in a nonvolatile memory device, e.g., a flash memory and/or an array structure of a SONOS memory. For example, the unit cell structure may include a NAND cell array structure of a NOR cell array structure.

Referring to FIGS. 1 - 4, the nonvolatile memory device may include four storage node layers 160a₁, 160a₂, 160b₁, and 160b₂ and a control gate electrode 140. A channel region (not shown), source regions S1 and S2, and drain regions D1 and D2 may be defined in fins 105a and 105b. The control gate electrode 140 may commonly control a pair of fins 105a and 105b. The nonvolatile memory device may process data of at least 4 bit using the four storage node layers 160a₁, 160a₂, 160b₁, and 160b₂.

A semiconductor substrate 110 may include a body 102 and first and second fins 105a and 105b that are separated from each other and protrude from the body 102. The fins 105a and 105b may be arranged in parallel, but not necessarily. For example, the semiconductor substrate 110 may be formed by etching a bulk silicon wafer, a bulk germanium wafer and/or a bulk silicon-germanium wafer. In other words, the fins 105a and 105b may be formed of the same material as the body 102.

A buried insulating layer 115 may be provided between the fins 105a and 105b. The buried insulating layer 115 may prevent or retard the control gate electrode 140 from extending between the fins 105a and 105b, for example, from covering the inner side of the fins 105a and 105b. In example embodiments, the sides of the fins 105a and 105b contacting the buried insulating layer 115 may be called inner sides, and the opposite sides of the buried insulating layer 115 may be called outer sides of the fins 105a and 105b. Accordingly, the height of the buried insulating layer 115 may be controlled, and for example, a void may remain between the buried insulating layer 115 and the body 102. The buried insulating layer 115 may include an oxide layer and/or a nitride layer, and may be formed using a conventional material layer forming method, e.g., a chemical vapor deposition method and/or a planarization method.

The control gate electrode 140 may be on the sides of the fins 105a and 105b opposite to the buried insulating layer 115, for example, the outer sides of the fins 105a and 105b, and may extend onto the buried insulating layer 115 and the fins 105a and 105b. However, the control gate electrode 140 may be disposed to insulate the semiconductor substrate 110, for example, from the body 102 and the fins 105a and 105b. For example, the control gate electrode 140 may insulate the body 102 by a lower insulating layer 120 and from the fins 105a and 105b by a gate insulating layer 130.

The lower insulating layer 120 may be illustrated to be between the control gate electrode 140 and the fins 105a and 105b, however, the lower insulating layer 120 may also extend to an exposed portion of the fins 105a and 105b to entirely cover the fins 105a and 105b. For example, the lower insulating layer 120 may include an oxide layer and/or a nitride layer. The control gate electrode 140 may include at least one of a polysilicon layer, a metal layer and/or a metal silicide layer. The lower insulating layer 120 and the control gate electrode 140 may be formed using a conventional material layer forming method, e.g., a chemical vapor deposition method and/or a patterning method.

The gate insulating layer 130 may be interposed or inserted between the fins 105a and 105b and the control gate electrode 140. The gate insulating layer 130 may extend onto the buried insulating layer 115 in FIGS. 1 - 4, but may not be formed over the buried insulating layer 115 depending on the forming method. For example, the gate insulating layer 130 may include a silicon oxide layer and a high k dielectric layer. The high k dielectric layer in example embodiments refers to an insulating layer having a higher dielectric constant than a silicon oxide layer. For example, the gate insulating layer 130 may be formed using a thermal oxidization method and/or a conventional material layer deposition method, e.g., a chemical vapor deposition method.

A first source region S1 and a first drain region D1 may be formed each on portions of the first fin 105a on both sides of the control gate electrode 140. For example, the first source region S1 and the first drain region D1 may be formed by doping impurities in the first fin 105a. As will be described later, the first source region S1 and the first drain region D1 may be separated from the control gate electrode 140 in order to increase the charge trapping efficiency of the first and second storage node layers 160a₁ and 160a₂. The first source region S1 and the first drain region D1 may be disposed so as not to overlap with the control gate electrode 140. A second source region S2 and a second drain region D2 may be formed each on portions of the second fin 105b on both sides of the control gate electrode 140. For example, the second source region S2 and the second drain region D2 may be formed by doping impurities to the second fin 105b. As will be described later, the first source region S2 and the first drain region D2 may be separated from the control gate electrode 140 in order to increase the charge trapping efficiency of the third and fourth storage node layers 160a_{b1} and 160a_{b2}. The second source region S2 and the second drain region D2 may be disposed so as not to overlap with the control gate electrode 140.

The first and second storage node layers 160a₁ and 160a₂ may be formed on a side of the first fin 105a opposite to the buried insulating layer 115 and the control gate electrode 140 may be interposed or inserted between the first and second storage node layers 160a₁ and 160a₂, for example, on the outer side of the first fin 105a. For example, at least a portion of the first and second storage node layers may be disposed so as not to overlap with the first source region S1 and the first drain region D1. For example, the first storage node layer 160a₁ may protrude from the first source region S1 toward the control gate electrode 140 and the second storage node layer 160a₂ may protrude from the first drain region D1 toward the control gate electrode 140.

In example embodiments, an end of the first source region S1 and the first drain region D1 may be fixed to the center of the first and second storage node layers 160a₁ and 160a₂. Thus, a portion of the first and second storage node layers 160a₁ and 160a₂ may be disposed on a depletion layer of the first source region S1 and the first drain region D1 to improve the operation characteristics of the nonvolatile memory device, as will be described later.

The third and fourth storage node layers 160b₁ and 160b₂ may be formed on a side of the second fin 105b opposite to the buried insulating layer 115 and the control gate electrode 140 may be interposed or inserted between the third and fourth storage node layers 160b₁ and 160b₂, for example, on the outer side of the second fin 105b. For example, at least a portion of the third and fourth storage node layers 160b₁ and 160b₂ may be disposed so as not to overlap with the second source region S2 and the second drain region D2. For example, the third storage node layer 160b₁ may protrude from the second source region S2 toward the control gate electrode 140 and the fourth storage node layer 160b₂ may protrude from the second drain region D2 toward the control gate electrode 140.

The third and fourth storage node layers 160b₁ and 160b₂ may be arranged symmetrically around the control gate electrode 140. As described above, the arrangement of the first through fourth storage node layers 160a₁, 160a₂, 160b₁, and 160b₂ may improve the operation characteristics of the nonvolatile memory device. For example, the first through fourth storage node layers 160a₁, 160a₂, 160b₁, and 160b₂ may include at least one selected from the group consisting of a silicon nitride layer, dots of metal or silicon and/or nano-crystals of metal or silicon.

The arrangement of the first through fourth storage node layers 160a₁, 160a₂, 160b₁, and 160b₂ may contribute to the improvement of integration of the nonvolatile memory device because the spacing of fins between each unit cell may reduce in an array structure. In other words, from the first fin 105a, the first tunnel insulating layer 150a, the first storage node layer 160a₁, the first blocking insulating layer 170a and the control gate electrode 140 may be stacked not sequentially but of two or three layers, thereby reducing the spacing between the fins 105a and 105b of the unit cells.

The semiconductor substrate 110 and the first through fourth storage node layers 160a₁, 160a₂, 160b₁, and 160b₂ may be separated. For example, the first tunnel insulating layer 150a may be interposed or inserted between the first fin 105a and the first and second storage node layers 160a₁ and 160a₂ and the second tunnel insulating layer 150b may be interposed or inserted between the second fin 105b and the third and fourth storage node layers 160b₁ and 160b₂. For example, the tunnel insulating layers 150a and 150b may include an oxide layer and/or a nitride layer, and may be formed using a thermal oxidization method and/or a conventional material layer deposition method. The thickness of the tunnel insulating layers 150a and 150b may be selected such that hot carriers may pass therethrough. Accordingly, the thickness of the tunnel insulating layers 150a and 150b and the gate insulating layer 130 may be controlled to be different from each other.

Selectively, a first blocking insulating layer 170a may be interposed or inserted between the control gate electrode 140 and the first and second storage node layers 160a₁ and 160a₂, and the second blocking insulating layer 170b may be interposed or inserted between the control gate electrode 140 and the third and fourth storage node layers 160b₁ and 160b₂. For example, the first and second blocking insulating layers 170a and 170b may be formed using a conventional material layer deposition method and an anisotropic etching method to contact a sidewall of the control gate electrode 140. The first and second blocking insulating layers 170a and 170b may include an oxide layer and/or a high k dielectric layer.

A depletion region formed at the fins 105a and 105b around the source regions S1 and S2 and the drain regions D1 and D2 may be relatively limited in the nonvolatile memory device in example embodiments. A depletion region may be formed in the horizontal direction of the fins 105a and 105b. Thus, the arrangement of the fins 105a and 105b and the buried insulating layer 115 may be called a structure similar to a conventional silicon-on-insulator (SOl) structure, for example, a SOl-like structure. The SOl-like structure may contribute to improvement of short channel effect that may occur by expansion of the depletion region. For example, the off current and the junction leakage current may be reduced. Unlike a conventional SOl structure, the advantage of applying body-bias to the fins 105a and 105b by applying voltage to the body 102 may be maintained.

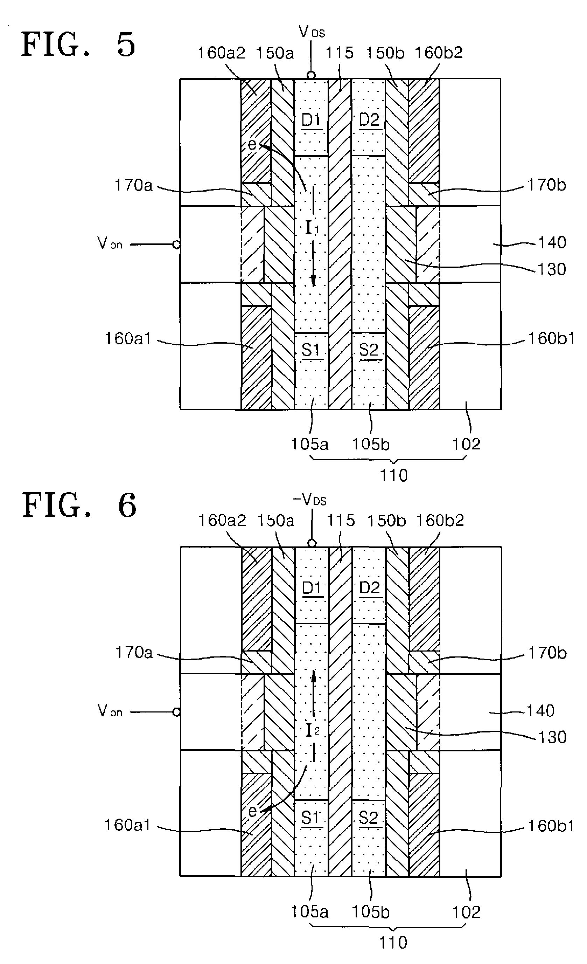

Hereinafter, the operation of the nonvolatile memory device according to example embodiments will be described with reference to FIGS. 5 - 9. FIGS. 5 - 9 are cross-sectional views of the nonvolatile memory device of FIG. 1 cut along a line V-V'. The nonvolatile memory device in example embodiments may have an n-type channel.

FIGS. 5 and 6 are cross-sectional views illustrating the programming operation of the nonvolatile memory device of example embodiments. A method of programming data to the second storage node layer 160a₂ will be described. Programming may be performed using a hot electron injection method. For example, when a turn-on voltage Vₒₙ, for example, a positive voltage is applied to the control gate electrode 140, and a positive voltage V_{DS} is applied between the first drain region D1 and the first source region S1, current l1 may flow from the first drain region D1 to the first source region S1 and electrons e may flow in the opposite direction. A larger depletion region may be formed around the drain region D1, and electrons e in the depletion region may be accelerated to the first drain region D1. However, because a positive voltage is applied to the control gate electrode 140, a portion of the accelerated electrons e may gain sufficient energy to pass through the first tunnel insulating layer 150a and may be injected to the second storage node layer 160a₂. The injection method of electrons e may be called hot electron injection (HEI) and/or channel hot electron injection (CHEI).

Because the first drain region D1 is separated from the control gate electrode 140, electrons may obtain relatively high energy between the control gate electrode 140 and the first drain region D1. Accordingly, hot carriers may be injected to a portion of the second storage node layer 160a₂ that is disposed between the control gate electrode 140 and the first drain region D1. Accordingly, efficiency of hot electron injection may be controlled by controlling the distance between the first drain region D1 and the control gate electrode 140.

A method of programming data to the first storage node layer 160a₁ will be described with reference to FIG. 6. The data programming method to the first storage node layer 160a₁ may be performed just in the opposite direction of the data programming method to the second storage node layer 160a₂. For example, when a turn-on voltage Vₒₙ, for example a positive voltage, is applied to the control gate electrode 140, and a negative voltage -V_{DS} is applied between the first drain region D1 and the first source region S1, current l2 may flow from the first source region S1 toward the first drain region D1 and electrons e may flow in the opposite direction.

As described with reference to FIG. 5, a larger depletion region may be formed around the first source region S1, and electrons e may be accelerated in the depletion region and obtain greater energy. Accordingly, the accelerated electrons may be injected to the first storage node layer 160a₁ that is adjacent to the first source region S1. The data program on the third storage node layer 160b₁ may be understood with reference to the description referring to FIG. 6, and the data program on the fourth storage node layer 160b₂ may be understood with reference to the description referring to FIG. 5.

For example, the data program on the third storage node layer 160b₁ may be performed by applying a positive voltage to the control gate electrode 140 by applying a negative voltage between the second drain region D2 and the second source region S2. The data program on the fourth storage node layer 160b₂ may be performed by applying a positive voltage to the control gate electrode 140 and by applying a positive voltage between the second drain region D2 and the second source region S2. Accordingly, separate data programs may be possible for the first through fourth storage node layers 160a₁, 160a₂, 160b₁, and 160b₂. A 4 bit program may be programmed using the programming method according to example embodiments. Using a multi-level programming method, a data program of more than 4 bit is also possible.

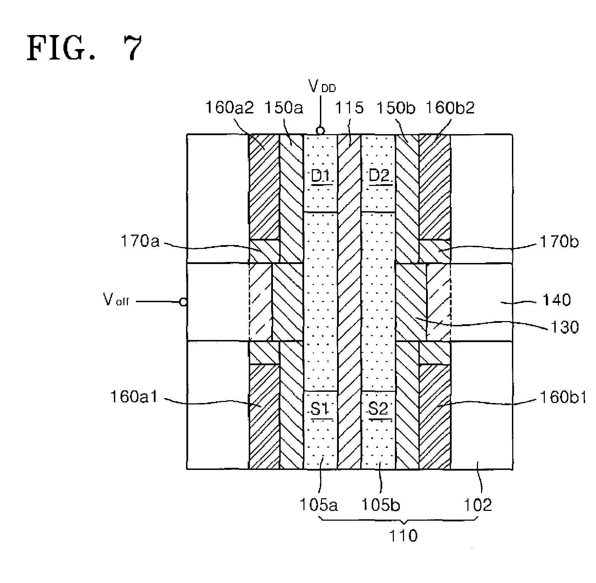

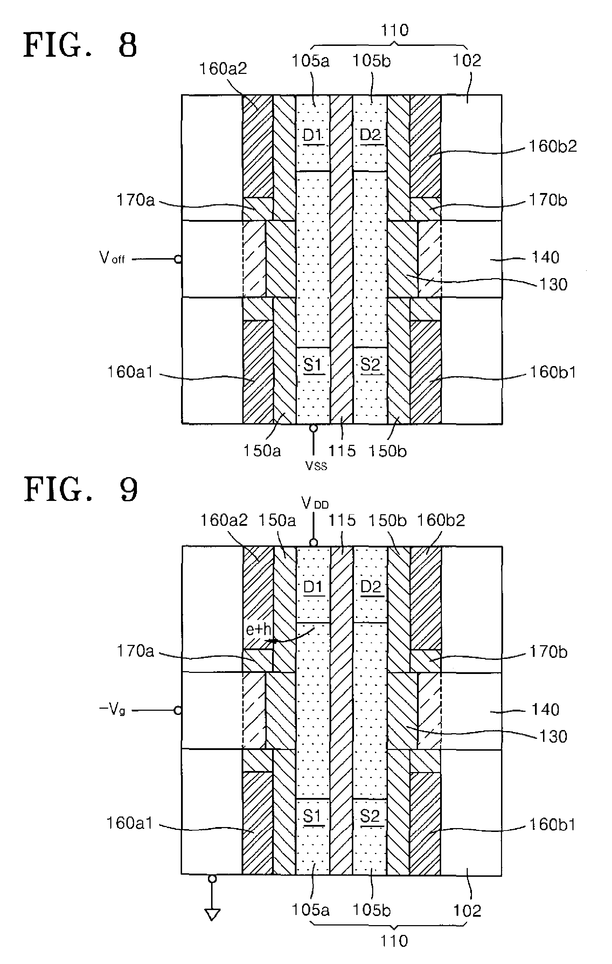

FIGS. 7 and 8 are cross-sectional views illustrating the reading operation of the nonvolatile memory device according to example embodiments. Referring to FIGS. 7 and 8, leakage currents of the first drain region D1 and the first source region S1 may be read to read data of the first and second storage node layers 160a₁ and 160a₂. For example, a turn-off voltage V_{off} may be applied to the control gate electrode 140 and a drain voltage may be applied to the first drain region D1 to measure the leakage current of the first drain region D1. Then a turn-off voltage V_{off} may be applied to the control gate electrode 140 and a source voltage Vₛₛ may be applied to the first source region S1 to measure the leakage current of the first source region S1. The main component of the leakage current of the first drain region D1 or the first source region S1 may be a gate induced drain leakage (GIDL) component.

The GIDL component may be influenced by the charges trapped in the first and second storage node layers 160a₁ and 160a₂. Accordingly, the leakage current may be measured by measuring the GIDL component whether the first and second storage node layers 160a₁ and 160a₂ store charges or not, for example, whether data is programmed or not. The turn-off voltage V_{off} may be about 0 V or a negative voltage, but reading efficiency is higher at a negative voltage. The data reading operation of the third and fourth storage node layers 160b₁ and 160b₂ may be easily carried out with reference to FIGS. 7 and 8. For example, a turn-off voltage may be applied to the control gate 140 and a drain voltage may be applied to the second drain region D2 to measure the leakage current of the second drain region D2. Also, a turn-off voltage may be applied to the control gate electrode 140 and a source voltage may be applied to the second source region S2 to measure the leakage current of the second source region S2.

FIG. 9 is a cross-sectional view showing the erasing operation of the nonvolatile memory device according to example embodiments. The erasing operation may use a hot hole injection (HHI) method. Referring to FIG. 9, data stored in the second storage node layer 160a₂ may be erased by injecting hot holes to the second storage node layer 160a₂. Electrons trapped in the second storage node layer 160a₂ and the hot holes injected to the second storage node layer 160a₂ may recombine. For example, when a positive voltage V_{DD} is applied to the first drain region D1 and a negative voltage -Vg is applied to the control gate electrode 140, hot holes may be injected to the second storage node layer160a₂.

Erasing of data stored in the first, third, and fourth storage node layers 160a₁, 160b₁, and 160b₂ may be carried out with reference to FIG. 9. For example, the erasing operation of the first, third, and fourth storage node layers 160a₁, 160b₁, and 160b₂ may be performed by applying a negative voltage to the control gate electrode 140 and by applying a positive voltage to the first source region S1, the second source region S2, and the second drain region D2. The body 102 may be grounded.

While example embodiments have been particularly shown and described with reference to example embodiments thereof, it will be understood by those of ordinary skill in the art that various changes in form and details may be made therein without departing from the scope of the following claims.

## Claims

1. A nonvolatile memory device comprising:
a first source region and a first drain region that are respectively in first fin portions on both sides of a control gate electrode and respectively separated from the control gate electrode;
a second source region and a second drain region that are respectively formed in second fin portions on both sides of the control gate electrode and respectively separated from the control gate electrode;
first and second storage node layers that are formed with the control gate electrode therebetween and on the side of the first fin opposite to a buried insulating layer between first and second fins; and
third and fourth storage node layers that are formed with the control gate electrode therebetween and on the side of the second fin opposite to the buried insulating layer.

2. The nonvolatile memory device of claim 1, further comprising:
a semiconductor substrate including the first and second fins;
a control gate electrode on the sides of the first and second fins opposite to the buried insulating layer and extending onto the buried insulating layer; and
a gate insulating layer between the first and second fins and the control gate electrode.

3. The nonvolatile memory device of claim 2, further comprising:
a first blocking layer between the control gate electrode and the first and second storage node layers; and
a second blocking insulating layer between the control gate electrode and the third and fourth storage node layers.

4. The nonvolatile memory device of claim 2, wherein the semiconductor substrate is an etched bulk semiconductor wafer.

5. The nonvolatile memory device of claim 2, wherein the semiconductor substrate includes a body and first and second fins that protrude from the body.

6. The nonvolatile memory device of claim 2, wherein the control gate electrode is insulated from the semiconductor substrate.

7. The nonvolatile memory device of any preceding claim, further comprising:
a first tunnel insulating layer between the first fin and the first and second storage node layers; and
a second tunnel insulating layer between the second fin and the third and fourth storage node layers.

8. The nonvolatile memory device of claim 7, wherein the gate insulating layer and the first and second tunnel insulating layers include an oxide layer.

9. The nonvolatile memory device of claim 8, wherein the thicknesses of the gate insulating layer and the first and second tunnel insulating layers are different from each other.

10. The nonvolatile memory device of any preceding claim, wherein at least a portion of the first and second storage node layers does not overlap with the first source region and the first drain region.

11. The nonvolatile memory device of any preceding claim, wherein at least a portion of the third and fourth storage node layers does not overlap with the second source region and the second drain region.

12. The nonvolatile memory device of any preceding claim, wherein the first, second, third, and fourth storage node layers include at least one selected from the group consisting of a silicon nitride layer, dots of metal or silicon, and nano-crystals of metal or silicon.

13. A method of operating a nonvolatile memory device comprising:
programming data of at least 4 bits to first, second, third, and fourth storage node layers;
reading data stored in the first, second, third, and fourth storage node layers; and
erasing the data stored in the first, second, third, and fourth storage node layers.

14. The method of claim 13, wherein programming the data includes using a hot electron injection (HEI) method.

15. The method of claim 14, wherein data programming is performed by supplying a turn-on voltage to a control gate electrode and by alternately applying currents in opposite directions to each other between a first source region and a first drain region and between a second source region and a drain region.

16. The method of claim 13, 14 or 15, wherein reading the data includes measuring the leakage current of a first source region and a first drain region and the leakage current of a second source region and a second drain region.

17. The method of claim 16, wherein in reading the data, a turn-off voltage is supplied to a control gate electrode.

18. The method of any of claims 13 to 17, wherein erasing the data includes using a hot hole injection (HHI) method.

19. The method of claim 18, wherein data erasing is performed by supplying a negative voltage to a control gate electrode and by supplying a positive voltage to at least one of a first source region, a first drain region, a second source region, and a second drain region.

20. The method of claim 19, wherein in erasing the data, the semiconductor substrate is grounded.

21. A method of manufacturing a nonvolatile memory device comprising:
forming a first source region and a first drain region that are respectively in the first fin portions on both sides of a control gate electrode and respectively separated from the control gate electrode;
forming a second source region and a second drain region on the second fin portions on both sides of the control gate electrode and respectively separated from the control gate electrode;
forming first and second storage node layers with the control gate electrode therebetween and on the side of the first fin opposite to a buried insulating layer between first and second fins; and
forming third and fourth storage node layers with the control gate electrode therebetween and on the side of the second fin opposite to the buried insulating layer.

22. The method of claim 21, further comprising:
providing a semiconductor substrate including the first and second fins;
forming a control gate electrode on the sides of the first and second fins opposite to the buried insulating layer and extending onto the buried insulating layer; and
forming a gate insulating layer between the first and second fins and the control gate electrode.

23. The method of claim 22, further comprising:
forming a first blocking layer between the control gate electrode and the first and second storage node layers; and
forming a second blocking insulating layer between the control gate electrode and the third and fourth storage node layers.

24. The method of claim 22 or 23, wherein the semiconductor substrate is an etched bulk semiconductor wafer.

25. The method of claim 22, 23 or 24, wherein the semiconductor substrate includes a body and first and second fins that protrude from the body.

26. The method of claim 22, 23, 24 or 25, wherein the control gate electrode is insulated from the semiconductor substrate.

27. The method of any of claims 21 to 26, further comprising:
forming a first tunnel insulating layer between the first fin and the first and second storage node layers; and
forming a second tunnel insulating layer between the second fin and the third and fourth storage node layers.

28. The method of claim 27, wherein the gate insulating layer and the first and second tunnel insulating layers include an oxide layer.

29. The method of claim 28, wherein the thicknesses of the gate insulating layer and the first and second tunnel insulating layers are different from each other.

30. The method of any of claims 21 to 29, wherein at least a portion of the first and second storage node layers does not overlap with the first source region and the first drain region.

31. The method of any of claims 21 to 30, wherein at least a portion of the third and fourth storage node layers does not overlap with the second source region and the second drain region.

32. The method of any of claims 21 to 31, wherein forming the first, second, third, and fourth storage node layers includes at least one selected from the group consisting of a silicon nitride layer, dots of metal or silicon, and nano-crystals of metal or silicon.
